(19) Europäisches Patentamt
European Patent Office
Office européen des brevets

(11) **EP 4 198 525 A1**

(12) **EUROPÄISCHE PATENTANMELDUNG**

(43) Veröffentlichungstag:
**21.06.2023 Patentblatt 2023/25**

(21) Anmeldenummer: **21215176.5**

(22) Anmeldetag: **16.12.2021**

(51) Internationale Patentklassifikation (IPC):
**G01R 19/25** (2006.01) **G01R 19/00** (2006.01)

(52) Gemeinsame Patentklassifikation (CPC):
**G01R 19/2513;** G01R 19/0007

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft
80333 München (DE)**

(72) Erfinder:
• **Aumann, Erhard
67550 Worms (DE)**
• **Mladenovic, Ivana
90556 Seukendorf (DE)**

(74) Vertreter: **Siemens Patent Attorneys
Postfach 22 16 34
80506 München (DE)**

(54) **SPANNUNGSMESSUNG IN ELEKTRISCHEN VERSORGUNGSNETZEN**

(57) Die Erfindung gibt ein Verfahren zur Ermittlung eines Wechselspannungssignals (u(t)) in einem elektrischen Versorgungsnetz (4) an. Es weist folgende Schritte auf:

a) Messung einer ersten Wechselspannung ($U_1$) eines ersten Wechselspannungssignals ($u_1(t)$) an einem induktiven Spannungswandler (1) des Versorgungsnetzes (4) bei einer ersten Frequenz ($f_1$), die kleiner als die Grenzfrequenz ($f_c$) des induktiven Spannungswandlers (1) ist,

b) zeitgleiche Messung einer zweiten Wechselspannung ($U_2$) eines zweiten Wechselspannungssignals ($u_2(t)$ an einem kapazitiven Spannungsteiler (2) des Versorgungsnetztes (4) bei der ersten Frequenz ($f_1$),

c) Ermittlung eines Korrekturfaktors (k) als Quotient aus der zweiten Wechselspannung ($U_2$) und der ersten Wechselspannung ($U_1$), und

d) Ermittlung des Wechselspannungssignals (u(t)) als Summe des ersten Wechselspannungssignals ($u_1(t)$) bei Frequenzen kleiner einer zweiten Frequenz ($f_2$), die kleiner als die Grenzfrequenz ($f_c$) ist, und dem mit dem Korrekturfaktor (k) multiplizierten zweiten Wechselspannungssignal ($u_2(t)$) bei Frequenzen (f) größer gleich der zweiten Frequenz ($f_2$).

Eine zugehörige Anordnung und eine Verwendung der Anordnung werden ebenfalls angegeben.

FIG 3

EP 4 198 525 A1

**Beschreibung**

GEBIET DER ERFINDUNG

Die Erfindung betrifft ein Verfahren und eine Anordnung zur Ermittlung eines Wechselspannungssignals in einem elektrischen Versorgungsnetz. Die Erfindung betrifft auch eine Verwendung der Anordnung.

HINTERGRUND DER ERFINDUNG

Bekannte induktive Spannungswandler für die Messung der Wechselspannung in elektrischen Versorgungsnetzen, insbesondere in Mittel- und Hochspannungsnetzen, besitzen bauartbedingt eine Grenzfrequenz. Durch einen erhöhten Einsatz von Leistungselektronikbauteilen kommt es in den elektrischen Netzen verstärkt zu Oberwellen. Die Oberwellen liegen oftmals in Frequenzbereichen, die höher sind als die Grenzfrequenz der in den Schaltanlagen eingesetzten Spannungswandler. Der Spannungswandler erfüllt damit seine (im Laufe der Zeit) verschärften Anforderungen nicht mehr und müsste ersetzt werden.

Laut wikipedia.org ist ein Spannungswandler im Bereich der elektrischen Energietechnik ein Messwandler zum Messen von Wechselspannung. Die Funktion eines Spannungswandlers besteht darin, die zu messende hohe Spannung auf geringe Spannungswerte proportional zu übertragen. Diese geringere Spannung, üblich sind Werte um 100 V, wird an Spannungsmessgeräte, Energiezähler und ähnliche Geräte übermittelt, wozu Spannungswandler für Messzwecke vorgesehen sind, oder an elektrische Schutz- und Steuerungseinrichtungen, wozu es Spannungswandler für Schutzzwecke gibt. Sie werden als induktive und als kapazitiver Spannungsteiler hergestellt, letztere für primäre Bemessungsspannungen (Nennwerte) bis über 1 MV.

Der Einsatzbereich der Spannungswandler liegt im Bereich der elektrischen Energieverteilung in Umspannwerken und Kraftwerken.

Es ist möglich den induktiven Spannungswandler durch ein verbessertes Messsystem zu ersetzen. Hierfür ist aber eine Abschaltung der Schaltanlage notwendig und dadurch ein kapitalintensiver Austausch.

ZUSAMMENFASSUNG DER ERFINDUNG

Es ist Aufgabe der Erfindung, eine Lösung anzugeben, die es erlaubt, Wechselspannungen größer 1 kHz mit induktiven Spannungswandlern kleinerer Grenzfrequenz hinreichend genau zu ermitteln.

Die Erfindung ergibt sich aus den Merkmalen der unabhängigen Ansprüche. Vorteilhafte Weiterbildungen und Ausgestaltungen sind Gegenstand der abhängigen Ansprüche. Weitere Merkmale, Anwendungsmöglichkeiten und Vorteile der Erfindung ergeben sich aus der nachfolgenden Beschreibung.

Ein erster Aspekt der Erfindung besteht darin, mit Hilfe eines an einer kapazitiven Schnittstelle ermittelten Korrekturfaktor die mit einem induktiven Spannungswandler ermittelte Wechselspannung zu korrigieren.

Der Unterschied zu bekannten Lösungen ist die Erzeugung eines Signals basierend auf zwei Sensorquellen sowie der Korrektur der einen Sensorquelle durch die andere Quelle. Der daraus resultierende Vorteil besteht darin, dass vorhandenen Messsysteme weiterverwendet werden können und keine Hochspannungsarbeiten notwendig sind.

Die Erfindung beansprucht ein Verfahren zur Ermittlung eines Wechselspannungssignals in einem elektrischen Versorgungsnetz, mit den Schritten:

a) Messung einer ersten Wechselspannung eines ersten Wechselspannungssignals an einem induktiven Spannungswandler des Versorgungsnetzes bei einer ersten Frequenz, die kleiner als die Grenzfrequenz des induktiven Spannungswandlers ist,
b) zeitgleiche Messung einer zweiten Wechselspannung eines zweiten Wechselspannungssignals an einem kapazitiven Spannungsteiler des Versorgungsnetztes bei der ersten Frequenz,
c) Ermittlung eines Korrekturfaktors als Quotient aus der zweiten Wechselspannung und der ersten Wechselspannung, und
d) Ermittlung des Wechselspannungssignals als Summe des ersten Wechselspannungssignals bei Frequenzen kleiner einer zweiten Frequenz, die kleiner als die Grenzfrequenz ist, und dem mit dem Korrekturfaktor multiplizierten zweiten Wechselspannungssignal bei Frequenzen größer gleich der zweiten Frequenz.

Bevorzugt ist die zweite Frequenz größer als die erste Frequenz.

In einer Weiterbildung kann der kapazitiver Spannungsteiler nach IEC/EN 61243-5/ IEC62271-2137/ IEC62271-206 ausgebildet sein.

In einer weiteren Ausführungsform kann die erste Frequenz 50 Hz sein.

In einer weiteren Ausgestaltung kann die zweite Frequenz zwischen 200 Hz und 2 kHz liegen.

In einer Weiterbildung kann der Korrekturfaktor um einen frequenzabhängigen Term erweitert werden, wobei der Term materialabhängig ist. Als Material wird zum Beispiel Epoxidharz in Kondensatoren verwendet.

Die Erfindung beansprucht auch eine Anordnung zur Ermittlung eines Wechselspannungssignals in einem elektrischen Versorgungsnetz, aufweisend:

- einen induktiven Spannungswandler des Versorgungsnetzes,
- eines kapazitiver Spannungsteiler des Versorgungsnetzes,
- eine Recheneinheit und
- einem Speicher einschließlich Programmcode, der, wenn er von der Recheneinheit ausgeführt wird, Operationen bereitstellt, die Folgendes umfassen:

a) Ermittlung einer ersten Wechselspannung eines ersten Wechselspannungssignals an dem induktiven Spannungswandler bei einer ersten Frequenz, die kleiner als die Grenzfrequenz des induktiven Spannungswandlers ist,

b) zeitgleiche Ermittlung einer zweiten Wechselspannung eines zweiten Wechselspannungssignals an dem kapazitiven Spannungsteiler bei der ersten Frequenz,

c) Ermittlung eines Korrekturfaktors als Quotient aus der zweiten Wechselspannung und der ersten Wechselspannung, und

d) Ermittlung des Wechselspannungssignals als Summe des ersten Wechselspannungssignals bei Frequenzen kleiner einer zweiten Frequenz, die kleiner als die Grenzfrequenz ist, und dem mit dem Korrekturfaktor multiplizierten zweiten Wechselspannungssignal bei Frequenzen größer gleich der zweiten Frequenz.

Außerdem beansprucht die Erfindung eine Verwendung der Anordnung zur Ermittlung einer Wechselspannung in einer Schaltanlage eines elektrischen Versorgungsnetzes. Eine Schaltanlage ist eine Anlage, in der elektrische Energie verteilt wird.

Weitere Besonderheiten und Vorteile der Erfindung werden aus den nachfolgenden Erläuterungen eines Ausführungsbeispiels anhand von schematischen Zeichnungen ersichtlich.

KURZE BESCHREIBUNG DER ZEICHNUNGEN

Es zeigen:

FIG. 1    Frequenzgänge von Spannungswandlern gemäß Stand der Technik,

FIG. 2    den Frequenzgang eines kapazitiven Spannungsteilers, und

FIG. 3    ein Blockschaltbild einer Messanordnung.

DETAILLIERTE BESCHREIBUNG DER ZEICHNUNGEN

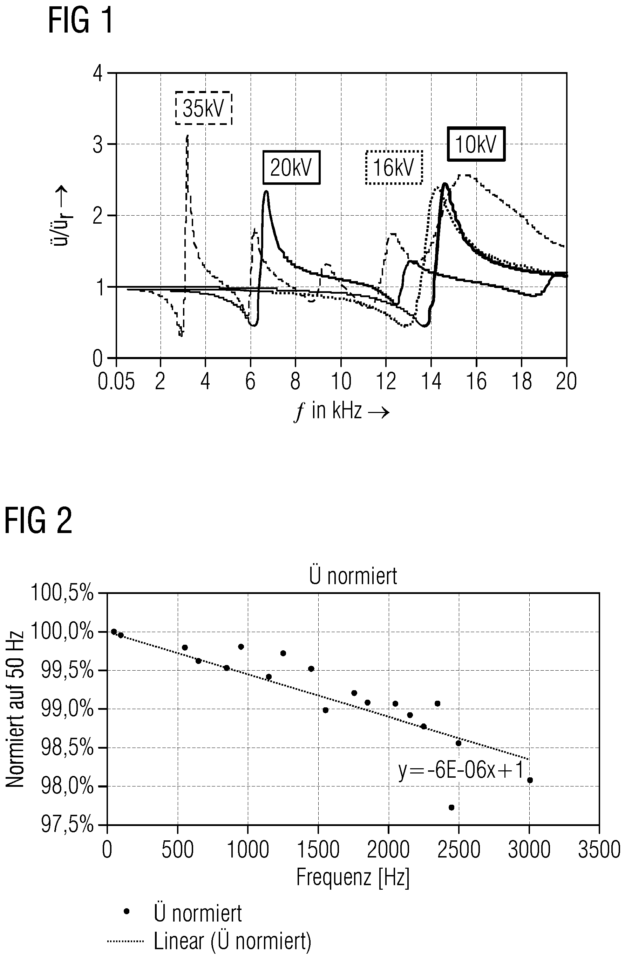

Es ist bekannt, beispielsweise aus der Offenlegungsschrift DE 10 2010 009 235 A1, dass zusätzlich zu einem induktiven Spannungswandler in den meisten Schaltanlagen auch ein kapazitiver Spannungswandler, beispielsweise einer Messschnittstelle nach IEC 61243-5, vorhanden ist. Als kapazitives Messverfahren hat ein derartiges System eine hohe Frequenzstabilität, jedoch nur eine geringe Messgenauigkeit, da insbesondere die Hochspannungskapazität durch Temperaturänderung und Einbauposition Schwankungen unterliegt. Diese Änderungen sind aber nur zu einem geringen Teil frequenzabhängig, wie aus FIG. 2 zu erkennen ist, die den Frequenzgang eines kapazitiven Spannungsteilers illustriert.

Spannungsprüfsysteme (Voltage detecting systems, VDS) nach IEC/EN 61243-5 sind Geräte, die einpolig kapazitiv an unter Spannung stehende Teile angekoppelt werden. Diese dürfen gemäß Normendefinition zum Feststellen der Spannungsfreiheit verwendet werden.

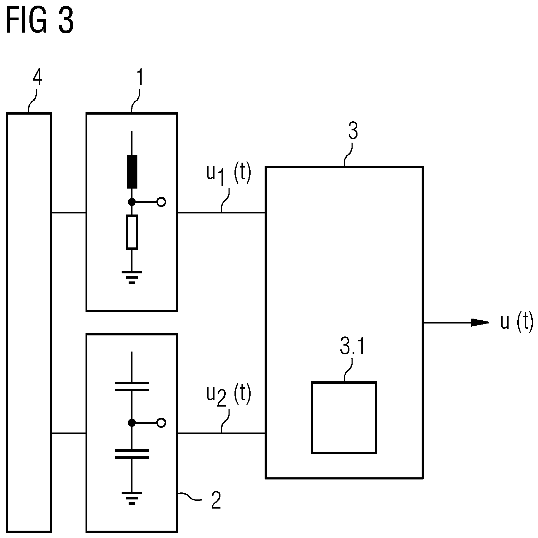

Eine Ausführungsform des Messverfahrens, ausgeführt mit einer Anordnung gemäß dem Blockschaltbild der FIG. 3, wird im Folgenden beschrieben. Das Verfahren basiert auf einem zeitsynchronisierten Vergleich des ersten Wechselspannungssignals $u_1(t)$ eines bekannten, konventionellen induktiven Spannungswandlers 1 eines elektrischen Versorgungsnetzes 4 und einem zweiten Wechselspannungssignals $u_2(t)$ eines korrespondierenden kapazitiven Spannungsteilers 2 des Versorgungsnetzes 4.

Dabei wird ein Korrekturfaktor k durch Division der zweiten Wechselspannung $U_2$ des zweiten Wechselspannungssignals $u_2(t)$ mit der ersten Wechselspannung $U_1$ des ersten Wechselspannungssignals $u_1(t)$ bei einer ersten Frequenz $f_1$ (eine niedrige Frequenz unterhalb der Grenzfrequenz $f_c$ des induktiven Spannungswandlers 1) ermittelt.

Der Korrekturfaktor k wird dann zur Korrektur des zweiten Wechselspannungssignals $u_2(t)$ bei hohen Frequenzen f, oberhalb einer zweiten Frequenz $f_2$ eingesetzt.

Das finale Wechselspannungssignal u(t) wird dann aus dem ersten Wechselspannungssignal $u_1(t)$ des induktiven Spannungswandlers 1 bei Frequenzen f unterhalb der zweiten Frequenz $f_2$ und dem korrigierten zweiten Wechselspannungssignal $u_{korr}(t)$ bei Frequenzen f größer gleich der zweiten Frequenz $f_2$ zusammengesetzt. Dies ist notwendig, damit die Systemgenauigkeit bei niedrigen Frequenzen weiterhin erhalten bleibt, da die Genauigkeit des korrigierten zweiten Wechselspannungssignals $u_{korr}(t)$ schlechter sein darf als die Genauigkeit des für die Korrektur zugrunde liegenden ersten Wechselspannungssignals $u_1(t)$. Bei höheren Frequenzen ist eine geringere Genauigkeit dagegen akzeptabel.

Die Berechnung in einer Recheneinheit 3 und einem Speicher 3.1 der Anordnung erfolgt in mathematischen Gleichungen ausgedrückt wie folgt:

$$k = \frac{U_{2,}}{U_1}$$

$$u_{korr}(t) = k \times u_2(t)$$

$$u(t) = u_1(t, f < f_2) + u_{korr}(t, f \geq f_2)$$

Da die Grenzfrequenz $f_c$ für unterschiedliche induktive Spannungsteiler 1 verschieden ist, wie aus FIG. 1 erkennbar, wird die zweite Frequenz $f_2$ dem induktiven Spannungswandler 1 angepasst gewählt. Die erste Frequenz $f_1$ ist bei üblichen 50 Hz Versorgungsnetzen 4 bevorzugt 50 Hz.

Für höhere Genauigkeiten kann weiterhin der Korrekturfaktor k auch durch materialspezifische Kennlinien des kapazitiver Spannungsteilers 1 (wie zum Beispiel von Gießharz) zu einem frequenzabhängigen Korrekturfaktor k(f) optimiert werden.

Beispielsweise kann ein bei 50 Hz ermittelte Korrekturfaktor k noch um einen beispielsweise messtechnisch erfassten Term y(f) (siehe FIG. 2) ergänzt werden:

```
k(f[Hz]) = k * y(f) = k *(1 - 6*10⁻⁶ * f[Hz])
```

Obwohl die Erfindung im Detail durch die Ausführungsbeispiele näher illustriert und beschrieben wurde, ist die Erfindung durch die offenbarten Beispiele nicht eingeschränkt und andere Variationen können vom Fachmann daraus abgeleitet werden, ohne den Schutzumfang der Erfindung zu verlassen.

Bezugszeichenliste

1 Induktiver Spannungswandler
2 Kapazitiver Spannungsteiler
3 Recheneinheit
3.1 Speicher
4 elektrisches Versorgungsnetz

f Frequenz
$f_c$ Grenzfrequenz
$f_1$ erste Frequenz
$f_2$ zweite Frequenz
k Korrekturfaktor
t Zeit
$u_{korr}(t)$ korrigiertes zweites Wechselspannungssignal
$u_1(t)$ erstes Wechselspannungssignal
$U_1$ erste Wechselspannung
$u_2(t)$ zweites Wechselspannungssignal

$U_2$       zweite Wechselspannung
$u(t)$      Wechselspannungssignal
$y(f)$      frequenzabhängiger Term

**Patentansprüche**

1.  Verfahren zur Ermittlung eines Wechselspannungssignals ($u(t)$) in einem elektrischen Versorgungsnetz (4), mit den Schritten:

    a) Messung einer ersten Wechselspannung ($U_1$) eines ersten Wechselspannungssignals ($u_1(t)$) an einem induktiven Spannungswandler (1) des Versorgungsnetzes (4) bei einer ersten Frequenz ($f_1$), die kleiner als die Grenzfrequenz ($f_c$) des induktiven Spannungswandlers (1) ist,
    b) zeitgleiche Messung einer zweiten Wechselspannung ($U_2$) eines zweiten Wechselspannungssignals ($u_2(t)$ an einem kapazitiven Spannungsteiler (2) des Versorgungsnetztes (4) bei der ersten Frequenz ($f_1$),
    c) Ermittlung eines Korrekturfaktors ($k$) als Quotient aus der zweiten Wechselspannung ($U_2$) und der ersten Wechselspannung ($U_1$), und
    d) Ermittlung des Wechselspannungssignals ($u(t)$) als Summe des ersten Wechselspannungssignals ($u_1(t)$) bei Frequenzen kleiner einer zweiten Frequenz ($f_2$), die kleiner als die Grenzfrequenz ($f_c$) ist, und dem mit dem Korrekturfaktor ($k$) multiplizierten zweiten Wechselspannungssignal ($u_2(t)$) bei Frequenzen ($f$) größer gleich der zweiten Frequenz ($f_2$).

2.  Verfahren nach Anspruch 1, **dadurch gekennzeichnet,**
    **dass** die zweite Frequenz ($f2$) größer als die erste Frequenz ($f_1$) ist.

3.  Verfahren nach Anspruch 1 oder 2, **dadurch gekennzeichnet, dass** der kapazitive Spannungsteiler (2) nach IEC/EN 61243-5/ IEC 62271-206/ IEC 62271-213 ausgebildet ist.

4.  Verfahren nach einem der Ansprüche 1 bis 3, **dadurch gekennzeichnet,**
    **dass** die erste Frequenz ($f_1$) 50 Hz ist.

5.  Verfahren nach einem der Ansprüche 1 bis 4, **dadurch gekennzeichnet,**
    **dass** die zweite Frequenz ($f_2$) zwischen 200 Hz und 2 kHz liegt.

6.  Verfahren nach einem der vorhergehenden Ansprüche, **dadurch gekennzeichnet,**
    **dass** der Korrekturfaktor ($k$) um einen frequenzabhängigen Term ($y(t)$) erweitert wird, wobei der Term ($y(t)$) vom Material des kapazitiven Spannungsteilers (2) abhängig ist.

7.  Anordnung zur Ermittlung eines Wechselspannungssignals ($u(t)$) in einem elektrischen Versorgungsnetz (4), aufweisend:

    - einen induktiven Spannungswandler (1) des Versorgungsnetzes (4),
    - einen kapazitiven Spannungsteiler (2) des Versorgungsnetzes (4),
    - eine Recheneinheit (3) und
    - einen Speicher (3.1) einschließlich Programmcode, der, wenn er von der Recheneinheit (3) ausgeführt wird, Operationen bereitstellt, die Folgendes umfassen:

      a) Ermittlung einer ersten Wechselspannung ($U_1$) eines ersten Wechselspannungssignals ($u_1(t)$) an dem induktiven Spannungswandler (1) bei einer ersten Frequenz ($f_1$), die kleiner als die Grenzfrequenz ($f_c$) des induktiven Spannungswandlers (1) ist,
      b) zeitgleiche Ermittlung einer zweiten Wechselspannung ($U_2$) eines zweiten Wechselspannungssignals ($u_2(t)$) an dem kapazitiven Spannungsteiler (2) bei der ersten Frequenz ($f_1$),
      c) Ermittlung eines Korrekturfaktors ($k$) als Quotient aus der zweiten Wechselspannung ($U$) und der ersten Wechselspannung ($U_1$), und
      d) Ermittlung des Wechselspannungssignals ($u(t)$) als Summe des ersten Wechselspannungssignals ($u_1(t)$) bei Frequenzen ($f$) kleiner einer zweiten Frequenz ($f_2$), die kleiner als die Grenzfrequenz ($f_c$) ist, und dem mit dem Korrekturfaktor ($k$) multiplizierten zweiten Wechselspannungssignal ($u_2(t)$) bei Frequenzen ($f$) größer gleich der zweiten Frequenz ($f_2$).

8. Anordnung nach Anspruch 7, **dadurch gekennzeichnet,**
   **dass** die zweite Frequenz ($f_2$) größer als die erste Frequenz ($f_1$) is.t

9. Anordnung nach Anspruch 7 oder 8,
   **dadurch gekennzeichnet,**
   **dass** der kapazitive Spannungsteiler (2) nach IEC/EN 61243-5/ IEC 62271-206/ IEC 62271-213 ausgebildet ist.

10. Anordnung nach einem der Ansprüche 7 bis 9, **dadurch gekennzeichnet,**
    **dass** die erste Frequenz ($f_1$) 50 Hz ist.

11. Anordnung nach einem der Ansprüche 7 bis 10, **dadurch gekennzeichnet,**
    **dass** die zweite Frequenz ($f_2$) zwischen 200 Hz und 2 kHz liegt.

12. Anordnung nach einem der Ansprüche 7 bis 11, **dadurch gekennzeichnet,**
    **dass** der Korrekturfaktor (k) um einen frequenzabhängigen Term (y(f)) erweitert wird, wobei der Term (y(f)) vom Material des kapazitiven Spannungsteilers (2) abhängig ist.

13. Verwendung einer Anordnung nach einem der Ansprüche 7 bis 12 zur Ermittlung eines Wechselspannungssignals (u(t)) in einer Schaltanlage eines elektrischen Versorgungsnetzes (4).

## FIG 1

## FIG 2

FIG 3

Europäisches
Patentamt

European
Patent Office

Office européen
des brevets

**EUROPÄISCHER RECHERCHENBERICHT**

**Nummer der Anmeldung**

**EP 21 21 5176**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2018 106200 A1 (INNOGY SE [DE]) 19. September 2019 (2019-09-19) * Absatz [0008] – Absatz [0050] * * Absatz [0063] – Absatz [0081]; Abbildungen 2-3 * ----- | 1-13 | INV. G01R19/25 G01R19/00 |
| A | WO 2005/031374 A1 (SIEMENS AG [DE]; JURISCH ANDREAS [DE]) 7. April 2005 (2005-04-07) * das ganze Dokument * ----- | 1-13 | |
| A | DE 28 51 731 A1 (KD ELEKTROIZMERIT PRIBOROV) 3. Juli 1980 (1980-07-03) * das ganze Dokument * ----- | 1-13 | |

**RECHERCHIERTE SACHGEBIETE (IPC)**

**G01R**

Der vorliegende Recherchenbericht wurde für alle Patentansprüche erstellt

| Recherchenort | Abschlußdatum der Recherche | Prüfer |
|---|---|---|
| **München** | **16. Mai 2022** | **Lyons, Christopher** |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

 

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 21 21 5176

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

16-05-2022

| Im Recherchenbericht angeführtes Patentdokument | Datum der Veröffentlichung | Mitglied(er) der Patentfamilie | Datum der Veröffentlichung |
|---|---|---|---|
| DE 102018106200 A1 | 19-09-2019 | CA 3094117 A1 | 19-09-2019 |
| | | DE 102018106200 A1 | 19-09-2019 |
| | | EP 3766157 A1 | 20-01-2021 |
| | | US 2021011061 A1 | 14-01-2021 |
| | | WO 2019174869 A1 | 19-09-2019 |
| WO 2005031374 A1 | 07-04-2005 | CN 1860372 A | 08-11-2006 |
| | | DE 10346356 A1 | 12-05-2005 |
| | | EP 1664804 A1 | 07-06-2006 |
| | | HK 1096456 A1 | 01-06-2007 |
| | | US 2006232264 A1 | 19-10-2006 |
| | | WO 2005031374 A1 | 07-04-2005 |
| DE 2851731 A1 | 03-07-1980 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010009235 A1